# EUROPEAN PATENT APPLICATION

(11) **EP 4 726 939 A1**
(43) Date of publication of application: **15.04.2026**
(21) Application number: 24822314.1
(22) Date of filing: 14.03.2024
(51) Int. Cl.: H01S 5/026, G02B 6/42, G02B 6/13, G02B 6/12, G02B 6/122, G02F 1/035, G02F 1/03, H01S 5/02, H01S 5/042

(54) **OPTICAL CHIP STRUCTURE AND MANUFACTURING METHOD THEREFOR**

(30) Priority: 12.06.2023 CN 202310691618
(71) Applicant: Innolight Technology (Suzhou) Ltd., Suzhou, Jiangsu 215000 (CN)
(72) Inventor: JI, Mengxi, Suzhou, Jiangsu 215000 (CN); LI, Xianyao, Suzhou, Jiangsu 215000 (CN); SUN, Yuzhou, Suzhou, Jiangsu 215000 (CN)
(74) Representative: Becker, Eberhard
(86) International application number: PCT/CN2024/081609
(87) International publication number: WO 2024/255356

(57) **Abstract**

The present application relates to an optical chip structure and a manufacturing method therefor. The method comprises: providing a base and a semi-finished chip, wherein the base comprises a first substrate, an isolation dielectric layer formed on the first substrate, a first semiconductor optical device, and a first waveguide, the semi-finished chip comprises a second substrate and a semi-finished thin-film layer located on one side of the second substrate, the semi-finished thin-film layer and the first waveguide are made of different materials, the first substrate comprises a silicon substrate; forming a recess in the isolation dielectric layer, wherein the first waveguide is at least partially located between the recess and the first substrate; bonding the semi-finished chip in the recess by means of the semi-finished thin-film layer, so that the semi-finished thin-film layer is optically coupled to the first waveguide; removing the second substrate of the semi-finished chip to form a second semiconductor optical device; and carrying out metallization to form an electrode structure separately connected to the first semiconductor optical device and the second semiconductor optical device.

## Description

The present disclosure claims the priority benefit of China application serial no. 202310691618.6, filed on June 12, 2023 with the CNIPA, and titled "OPTICAL CHIP STRUCTURE AND MANUFACTURING METHOD THEREFOR". The entirety of the above-mentioned patent application is hereby incorporated by reference herein and made a part of this specification.

### Technical Field

The present disclosure relates to the field of photonic integration technology, and particularly relates to an optical chip structure and a manufacturing method therefor.

### Description of Related Art

With the advancement of photonic integration technology, conventional optical chip structures are characterized by high integration and low cost. Additionally, conventional optical chip structures may be integrated with modulators, enabling them to perform optoelectronic transceiver functions.

However, despite the fact that conventional optical chip structures are able to perform optoelectronic transceiver functions, conventional optical chip structures encounter significant challenges during the manufacturing process. These challenges arise from the integration of materials from different material systems, which results in a high level of process complexity.

### SUMMARY OF DISCLOSURE

Based on the foregoing, it is necessary to provide an optical chip structure and a method for manufacturing the same to address the problem of high process difficulty in the fabrication process of optical chip structures in conventional technology due to the integration of materials from different material systems.

In order to achieve the above objective, on one hand, the present disclosure provides a method for manufacturing an optical chip structure, including:
Providing a base and a semi-finished chip, wherein the base includes a first substrate, an isolation dielectric layer formed on the first substrate, a first semiconductor optical device, and a first waveguide, the semi-finished chip includes a second substrate and a semi-finished thin-film layer located on one side of the second substrate, the semi-finished thin-film layer and the first waveguide are made of materials from different material systems, and the first substrate includes a silicon substrate;
Forming a recess in the isolation dielectric layer, wherein the first waveguide is at least partially located between the recess and the first substrate;
Bonding the semi-finished chip in the recess by means of the semi-finished thin-film layer, so that the semi-finished thin-film layer is optically coupled to the first waveguide;
Removing the second substrate of the semi-finished chip to form a second semiconductor optical device; and
Carrying out metallization to form an electrode structure separately connected to the first semiconductor optical device and the second semiconductor optical device.

In the above method for manufacturing the optical chip structure, the recess is formed in the isolation dielectric layer, and the semi-finished chip is bonded in the recess through the semi-finished thin-film layer, so that the first waveguide is well integrated with the semi-finished thin-film layer from different material systems, thus effectively reducing the process difficulty.

In addition, the formation of the recess facilitates the transmission of light between the first semiconductor optical device and the second semiconductor optical device. Meanwhile, the formation of the recess also allows the back-end metallization process to be performed conveniently and simultaneously between multiple devices, thereby saving process steps.

In an embodiment, the isolation dielectric layer with a preset thickness is provided between the bottom of the recess and the first waveguide;
The operation of bonding the semi-finished chip in the recess through the semi-finished thin-film layer so that the semi-finished thin-film layer is optically coupled to the first waveguide includes:
Bonding the semi-finished thin-film layer with the isolation dielectric layer.

In an embodiment, the semi-finished chip includes a thin-film lithium niobate chip. The semi-finished thin-film layer includes a thin-film lithium niobate layer, and the formed second semiconductor optical device includes a lithium niobate modulator.

In an embodiment, the semi-finished chip includes a laser chip. The semi-finished thin-film layer includes a Group III-V semiconductor material thin-film layer, and the formed second semiconductor optical device includes a laser.

In an embodiment, the operation of removing the second substrate of the semi-finished chip to form the second semiconductor optical device includes:
Removing the second substrate of the semi-finished chip;
Etching the semi-finished thin-film layer to form an electrode contact region and an optical processing region;
Filling a protective dielectric layer in the recess, and the protective dielectric layer covers the second semiconductor optical device.

In an embodiment, the first waveguide includes a first sub-waveguide and a second sub-waveguide. The semi-finished chip includes a first semi-finished chip and a second semi-finished chip. The first semi-finished chip is optically coupled to and connected with the first sub-waveguide, and the second semi-finished chip is optically coupled to and connected with the second sub-waveguide.

In an embodiment, the first semi-finished chip is a thin-film lithium niobate chip, the second semi-finished chip is a laser chip, and the first semi-finished chip and the second semi-finished chip are optically connected to each other through the first sub-waveguide and the second sub-waveguide.

In an embodiment, the first semiconductor optical device includes a waveguide layer, and the first waveguide and the waveguide layer of the first semiconductor optical device are located at the same layer.

In an embodiment, the first waveguide and the waveguide layer of the first semiconductor optical device are formed in one process flow.

The present disclosure also provides an optical chip structure, including:
A base, including a first substrate, an isolation dielectric layer located on the first substrate, a first semiconductor optical device, and a first waveguide;
A second semiconductor optical device, bonded to the isolation dielectric layer on the first waveguide, and optically coupled to and connected with the first waveguide, the first waveguide is at least partially located between the second semiconductor optical device and the first substrate;
An electrode structure, connected to the first semiconductor optical device and the second semiconductor optical device, respectively;
The first semiconductor optical device and the second semiconductor optical device are optically connected to each other through the first waveguide.

In an embodiment, the isolation dielectric layer with a preset thickness is provided between the first waveguide and the second semiconductor optical device.

An embodiment further includes:
A protective dielectric layer, covering the second semiconductor optical device.

In an embodiment, the first waveguide includes a first sub-waveguide and a second sub-waveguide. The second semiconductor optical device includes a first semiconductor sub-device and a second semiconductor sub-device. The first semiconductor sub-device is optically coupled to and connected with the first sub-waveguide, and the second semiconductor sub-device is optically coupled to and connected with the second sub-waveguide.

In an embodiment, the first semiconductor sub-device is a lithium niobate modulator, the second semiconductor sub-device is a laser, and the first semiconductor sub-device and the second semiconductor sub-device are optically connected to each other through the first sub-waveguide and the second sub-waveguide.

In an embodiment, the first semiconductor optical device is a detector, the second semiconductor optical device is a lithium niobate modulator, and the first semiconductor optical device and the second semiconductor optical device are optically connected to each other through the first waveguide.

### BRIEF DESCRIPTION OF THE DRAWINGS

In order to more clearly illustrate the technical solutions in the embodiments of the present disclosure or in the conventional technology, the following will briefly introduce the drawings that need to be used in the description of the embodiments or the conventional technology. Clearly, the drawings in the following description are only some embodiments of the present disclosure. For those of ordinary skill in the art, other drawings may also be obtained according to these drawings without creative effort.
FIG. 1 is a flowchart of a method for manufacturing an optical chip structure provided in an embodiment;
FIG. 2 is a schematic diagram of a cross-sectional structure of an optical chip structure provided in an embodiment;
FIG. 3 to FIG. 9 are schematic diagrams of cross-sectional structures obtained during the manufacturing process of an optical chip structure provided in an embodiment;
FIG. 10 to FIG. 20 are schematic diagrams of cross-sectional structures obtained during the manufacturing process of an optical chip structure provided in another embodiment.

Description of reference numerals: 110-first substrate, 120-second substrate, 210-isolation dielectric layer, 211-first dielectric layer, 212-second dielectric layer, 220-protective dielectric layer, 221-third dielectric layer, 222-fourth dielectric layer, 300-first semiconductor optical device, 310-germanium-silicon detector, 320-silicon-based modulator, 330-thermo-optic modulator, 340-passive device, 410-first waveguide, 411-first sub-waveguide, 412-second sub-waveguide, 420-waveguide layer, 510-semi-finished thin-film layer, 520-buried oxide layer, 600-recess, 610-first recess, 620-second recess, 700-electrode structure.

### DESCRIPTION OF THE EMBODIMENTS

For ease of understanding the present disclosure, the present disclosure will be described more comprehensively below with reference to the related drawings. The drawings show embodiments of the present disclosure. However, the present disclosure may be implemented in many different forms and is not limited to the embodiments described herein. On the contrary, these embodiments are provided to make the disclosure of the present disclosure more thorough and comprehensive.

Unless otherwise defined, all technical and scientific terms used herein have the same meaning as commonly understood by one of ordinary skill in the technical field to which the present disclosure belongs. The terms used herein in the specification of the present disclosure are only for the purpose of describing specific embodiments and are not intended to limit the present disclosure.

It should be understood that when an element or layer is referred to as being "on," "adjacent to," "connected to," or "coupled to" another element or layer, it may be directly on, adjacent to, connected or coupled to the other element or layer, or intervening elements or layers may be present. Conversely, when an element is referred to as being "directly on," "directly adjacent to," "directly connected to," or "directly coupled to" another element or layer, then no intervening elements or layers are present. It should be understood that although the terms first, second, third, etc. may be used to describe various elements, components, regions, layers, doping types and/or parts, these elements, components, regions, layers, doping types and/or parts should not be limited by these terms. These terms are only used to distinguish one element, component, region, layer, doping type or part from another element, component, region, layer, doping type or part. Thus, a first element, component, region, layer, doping type or part discussed below could be termed a second element, component, region, layer or part without departing from the teachings of the present disclosure.

Spatial relationship terms such as "under," "below," "lower," "beneath," "above," "on top of," etc. may be used herein to describe the relationship of one element or feature shown in the drawings to other elements or features. It should be understood that the spatial relationship terms are intended to encompass different orientations of the device in use or operation in addition to the orientation depicted in the figures. For example, if the device in the figures is turned over, elements or features described as "below" or "beneath" or "under" other elements or features would then be oriented "above" the other elements or features. Thus, the exemplary terms "below" and "under" may encompass both an orientation of above and below. Furthermore, the device may also be otherwise oriented (rotated 90 degrees or at other orientations) and the spatial descriptors used herein interpreted accordingly.

As used herein, the singular forms "a," "an," and "the" may also include the plural forms, unless the context clearly indicates otherwise. It should also be understood that the terms "include/comprise" or "have" etc. specify the presence of stated features, integers, steps, operations, components, parts, or combinations thereof, but do not preclude the presence or addition of one or more other features, integers, steps, operations, components, parts, or combinations thereof.

Embodiments of the present disclosure are described herein with reference to cross-sectional views that are schematic illustrations of idealized embodiments (and intermediate structures) of the present disclosure. As such, variations from the shapes of the illustrations as a result, for example, of manufacturing techniques and/or tolerances, are to be anticipated. Thus, embodiments of the present disclosure should not be construed as limited to the particular shapes of regions illustrated herein but are to include deviations in shapes that result, for example, from manufacturing techniques.

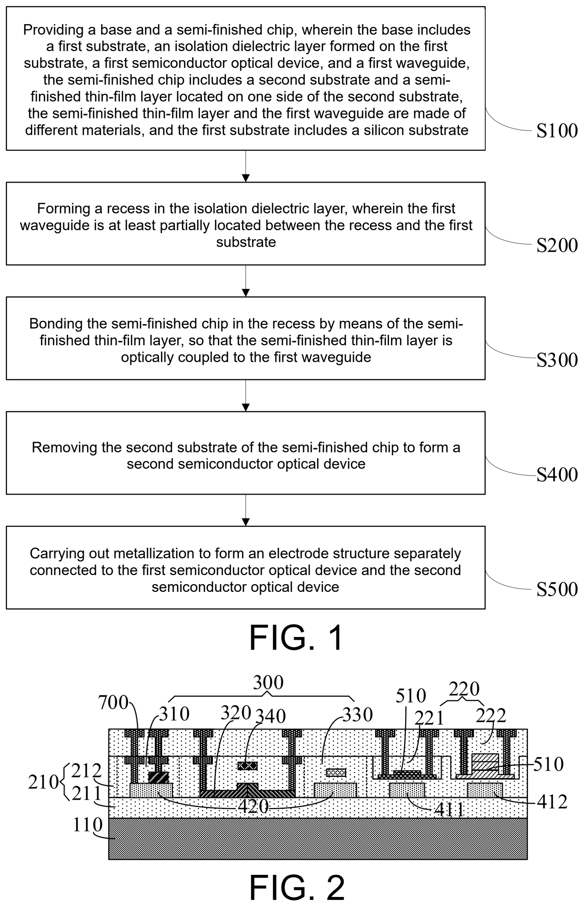

In an embodiment, please refer to FIG. 1, a method for manufacturing an optical chip structure is provided, including:
Step S100, providing a base and a semi-finished chip, the base including a first substrate 110, an isolation dielectric layer 210 formed on the first substrate 110, a first semiconductor optical device 300, and a first waveguide 410, the semi-finished chip including a second substrate 120 and a semi-finished thin-film layer 510 located on one side of the second substrate 120, the semi-finished thin-film layer 510 and the first waveguide 410 being made of materials of different material systems, the first substrate 110 including a silicon substrate;
Step S200, forming a recess 600 within the isolation dielectric layer 210, the first waveguide 410 being at least partially located between the recess 600 and the first substrate 110;
Step S300, bonding the semi-finished chip within the recess 600 through the semi-finished thin-film layer 510, such that the semi-finished thin-film layer 510 and the first waveguide 410 are optically coupled to each other;
Step S400, removing the second substrate 120 of the semi-finished chip to form a second semiconductor optical device;
Step S500, performing metallization to form an electrode structure 700 connected to the first semiconductor optical device 300 and the second semiconductor optical device, respectively.

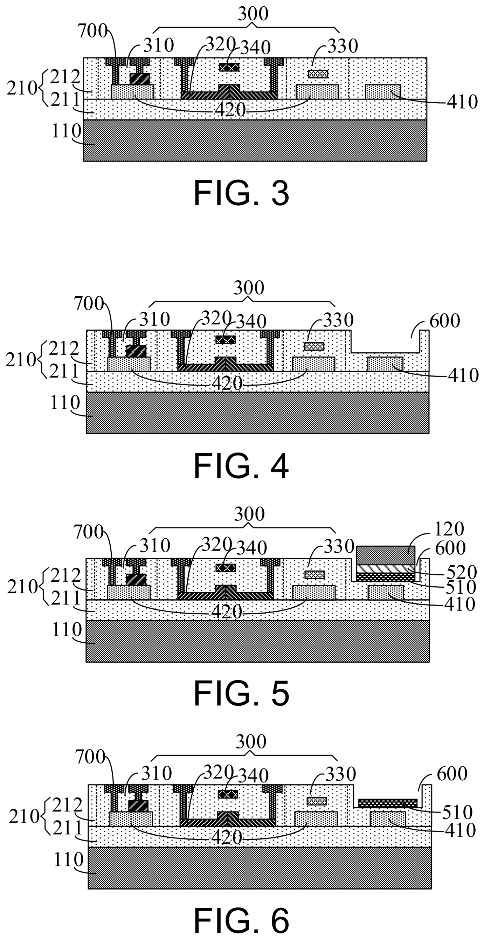

In step S100, please refer to FIG. 3, the base includes the first substrate 110, the isolation dielectric layer 210 formed on the first substrate 110, the first semiconductor optical device 300, and the first waveguide 410. Specifically, the first substrate 110 may include a silicon substrate. The isolation dielectric layer 210 is directly formed on the first substrate 110, and the first semiconductor optical device 300 and the first waveguide 410 are formed within the isolation dielectric layer 210. For example, the first semiconductor optical device 300 includes a germanium-silicon detector 310 and a silicon-based modulator 320. The isolation dielectric layer 210 may adopt a silicon dioxide (SiO₂) material.

In the present embodiment, when the first substrate 110 is a silicon substrate, the optical chip is a silicon optical chip. The silicon optical chip includes the isolation dielectric layer 210. The isolation dielectric layer 210 may include a first dielectric layer 211 and a second dielectric layer 212. The first dielectric layer 211 is directly formed on the first substrate 110, the second dielectric layer 212 is formed on the first dielectric layer 211, and the first semiconductor optical device 300 and the first waveguide 410 may both be formed within the second dielectric layer 212. The first semiconductor optical device 300 may receive external light.

The semi-finished chip includes the second substrate 120 and the semi-finished thin-film layer 510 located on one side of the second substrate 120. Specifically, the second substrate 120 may include but is not limited to a silicon substrate, in addition, the second substrate 120 may also be, for example, a silicon germanium (SiGe) substrate, a silicon germanium carbon (SiGeC) substrate, a silicon carbide (SiC) substrate, a gallium arsenide (GaAs) substrate, an indium arsenide (InAs) substrate, an indium phosphide (InP) substrate, or other Group III/V semiconductor substrates or Group II/VI semiconductor substrates. The type of the second substrate 120 does not limit the scope to be protected by the present disclosure.

The semi-finished thin-film layer 510 and the first waveguide 410 may be made of materials from different material systems, for example, when the semi-finished thin-film layer 510 adopts a lithium niobate material, the first waveguide 410 may adopt silicon (Si) or a silicon nitride (SiN) material from a Group IV material system.

In step S200, please refer to FIG. 4, the recess 600 is formed within the isolation dielectric layer 210, for example, the isolation dielectric layer 210 includes a first dielectric layer 211 and a second dielectric layer 212, the second dielectric layer 212 may be etched to form the recess 600, and the recess 600 is located within the second dielectric layer 212.

As an example, a depth of the recess 600 may be 1.5µm.

The first waveguide 410 is at least partially located between the recess 600 and the first substrate 110. A length of the first waveguide 410 may be greater than a width of the recess 600, and the first waveguide 410 is located below the recess 600 and within the isolation dielectric layer 210 above the first substrate 110.

In step S300, please refer to FIG. 5, the semi-finished thin-film layer 510 is in direct contact with the bottom of the recess 600. The semi-finished chip is bonded within the recess 600 through the semi-finished thin-film layer 510. Under the circumstances, the semi-finished thin-film layer 510 may be optically coupled to the first waveguide 410.

In step S400, please refer to FIG. 6, the second substrate 120 of the semi-finished chip is removed to form the second semiconductor optical device.

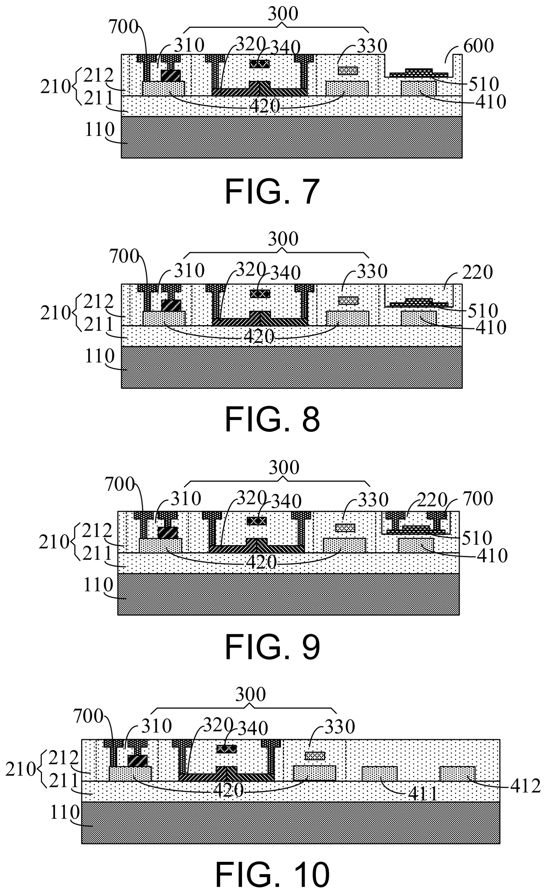

In step S500, please refer to FIG. 9, the electrode structure 700 may metallize the first semiconductor optical device 300 and the second semiconductor optical device. The electrode structure 700 connected to the second semiconductor optical device may be formed together with the electrode structure 700 connected to the first semiconductor optical device 300, both may be formed in the same process flow, thereby effectively saving the process steps and improving the process efficiency.

Various devices may also be formed within the base, such as a thermo-optic modulator 330 and a passive device 340. The thermo-optic modulator 330 may adopt a titanium nitride (TiN) material, and may also adopt other materials, which is not limited here. The passive device 340 may adopt a silicon nitride (SiN) material, the material of the passive device 340 is also not limited thereto, and may be selected according to actual conditions. Integrating multiple devices simultaneously in the optical chip improves the integration of the optical chip, thereby improving the functionality of the optical chip.

In this embodiment, the recess 600 is formed within the isolation dielectric layer 210, and the semi-finished chip is bonded within the recess 600 through the semi-finished thin-film layer 510, so that the first waveguide 410 is well integrated with the semi-finished thin-film layer 510 from different material systems, thereby effectively reducing the process difficulty.

In addition, the formation of the recess 600 contributes to light transmission between the first semiconductor optical device 300 and the second semiconductor optical device. Meanwhile, the formation of the recess 600 also allows the back-end metallization process to be performed conveniently and simultaneously among multiple devices, thereby saving process steps.

In an embodiment, please refer to FIG. 5, the isolation dielectric layer 210 with a preset thickness is provided between the bottom of the recess 600 and the first waveguide 410. In step S300, the operation of bonding the semi-finished chip within the recess 600 through the semi-finished thin-film layer 510 so that the semi-finished thin-film layer 510 is optically coupled to the first waveguide 410 includes:
Bonding the semi-finished thin-film layer 510 with the isolation dielectric layer 210.

When etching the isolation dielectric layer 210 to form the recess 600, the bottom of the recess 600 may not contact the first waveguide 410, a gap is formed between the recess 600 and the first waveguide 410, and the isolation dielectric layer 210 with a preset thickness is retained at the bottom of the recess 600. For example, the preset thickness may be 80nm. Under the circumstances, the semi-finished thin-film layer 510 is bonded with the isolation dielectric layer 210.

As an example, when the isolation dielectric layer 210 includes the first dielectric layer 211 and the second dielectric layer 212, the second dielectric layer 212 with a preset thickness is retained at the bottom of the recess 600.

In this embodiment, by retaining the isolation dielectric layer 210 between the bottom of the recess 600 and the first waveguide 410, the semi-finished thin-film layer 510 is bonded with the isolation dielectric layer 210, thereby further facilitating the optimization of device performance.

In an embodiment, in step S400, the operation of removing the second substrate 120 of the semi-finished chip to form the second semiconductor optical device includes:
Step S410, removing the second substrate 120 of the semi-finished chip;
Step S420, etching the semi-finished thin-film layer 510 to form an electrode contact region and an optical processing region;
Step S430, filling a protective dielectric layer 220 within the recess 600, and the protective dielectric layer 220 covers the second semiconductor optical device.

In step S410, the second substrate 120 of the semi-finished chip is removed, retaining the semi-finished thin-film layer 510.

In step S420, please refer to FIG. 7, the semi-finished thin-film layer 510 is etched to form the semi-finished thin-film layer 510 into a preset shape, thereby forming the electrode contact region and the optical processing region. The electrode contact region may be formed with electrode structures, and the optical processing region may perform optical functions such as generating laser or modulating and absorbing light. Specifically, dry etching may be adopted, and the dry etching includes at least any one of reactive ion etching (RIE), inductively coupled plasma etching (ICP), or high density plasma etching (HDP). Since dry etching has anisotropic characteristics, it may be possible to form the semi-finished thin-film layer 510 into a preset shape.

In step S430, please refer to FIG. 8, the protective dielectric layer 220 is filled within the recess 600, and the protective dielectric layer 220 covers the second semiconductor optical device.

The protective dielectric layer 220 may adopt a silicon dioxide (SiO₂) material same as the isolation dielectric layer 210. Of course, the materials of the protective dielectric layer 220 and the isolation dielectric layer 210 may also be different, which is not limited here.

After step S430, metal stacks connected to the second semiconductor optical device may also be formed. The number of metal stacks is not limited here. The metal stack facilitates the routing of the entire optical chip, and additionally, other devices may be formed between the metal stacks.

In an embodiment, please refer to FIG. 3, a base and a semi-finished chip are provided. The base includes the first substrate 110, the isolation dielectric layer 210 formed on the first substrate 110, the first semiconductor optical device 300, and the first waveguide 410. When the semi-finished chip is a thin-film lithium niobate chip, the thin-film lithium niobate chip includes the second substrate 120 and a thin-film lithium niobate layer located on one side of the second substrate 120. The thin-film lithium niobate layer and the first waveguide 410 are made of materials from different material systems. When the semi-finished chip is a laser chip, the laser chip includes the second substrate 120 and a laser thin-film layer 512 located on one side of the second substrate 120. The laser thin-film layer 512 and the first waveguide 410 are made of materials from different material systems.

In an embodiment, please refer to FIG. 5, the thin-film lithium niobate chip is bonded within the recess 600 through the thin-film lithium niobate layer, so that the thin-film lithium niobate layer is optically coupled to the first waveguide 410. Alternatively, the laser chip is bonded within the recess 600 through a Group III-V semiconductor material thin-film layer, so that the Group III-V semiconductor material thin-film layer is optically coupled to the first waveguide 410.

In an embodiment, please refer to FIG. 6, when the semi-finished chip is a thin-film lithium niobate chip, the second substrate 120 of the thin-film lithium niobate chip is removed, and the thin-film lithium niobate layer is retained. Specifically, the second substrate 120 includes a substrate layer and a buried oxide layer 520 (BOX), and the buried oxide layer 520 (BOX) may be formed through oxygen ion implantation. The entire second substrate 120 including the substrate layer and the buried oxide layer 520 (BOX) is removed, and only the thin-film lithium niobate layer remains in the recess 600.

Alternatively, when the semi-finished chip is a laser chip, the laser chip forms a n-type semiconductor layer and a p-type semiconductor layer before bonding, thereby forming the semi-finished chip. This design may avoid incompatibility of chips from different material systems during the process. The second substrate 120 of the laser chip serving as the semi-finished chip is removed, and the Group III-V semiconductor material thin-film layer is retained. Specifically, the stacked n-type semiconductor layer, a light-emitting layer, and the p-type semiconductor layer are retained.

In an embodiment, please refer to FIG. 7, when the semi-finished chip is a thin-film lithium niobate chip, the semi-finished thin-film is a thin-film lithium niobate layer, and the thin-film lithium niobate layer is etched to form the electrode contact region and the optical processing region. For example, when the thin-film lithium niobate layer is etched, the thin-film lithium niobate layer may be etched into a preset shape " 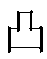 ". Under the circumstances, etching a portion of the thin-film lithium niobate layer is required, that is, etching both sides of the thin-film lithium niobate layer to make the height of both sides less than the height of the middle part of the thin-film lithium niobate layer, thereby forming the electrode contact region on both sides of the thin-film lithium niobate layer. Designing the thin-film lithium niobate layer to have the preset shape " 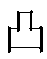 " may enable the lithium niobate modulator to obtain a better performance.

Alternatively, when the semi-finished chip is a laser chip, the semi-finished thin-film layer is the Group III-V semiconductor material thin-film layer, and the Group III-V semiconductor material thin-film layer is etched to form the electrode contact region and the optical processing region. Specifically, the p-type semiconductor, the light-emitting layer, and the n-type semiconductor layer are etched in sequence. For example, the Group III-V semiconductor material thin-film layer may be etched into a preset shape of " 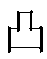 ". Under the circumstances, the laser chip first forms the n-type semiconductor layer, the light-emitting layer, and the p-type semiconductor layer before bonding, thereby forming the semi-finished chip, and the laser chip serving as the semi-finished chip is etched so that both sides of the p-type semiconductor and both sides of the light-emitting layer are completely etched away, while both sides of the n-type semiconductor layer retain partial thickness and are only partially etched.

In an embodiment, please refer to FIG. 8, when the second semiconductor optical device is a lithium niobate modulator, the lithium niobate modulator is covered by the protective dielectric layer 220, specifically, the lithium niobate modulator is covered by a third dielectric layer 221. Alternatively, when the second semiconductor optical device is a laser, the laser is covered by the protective dielectric layer 220, specifically, the laser is covered by a fourth dielectric layer 222.

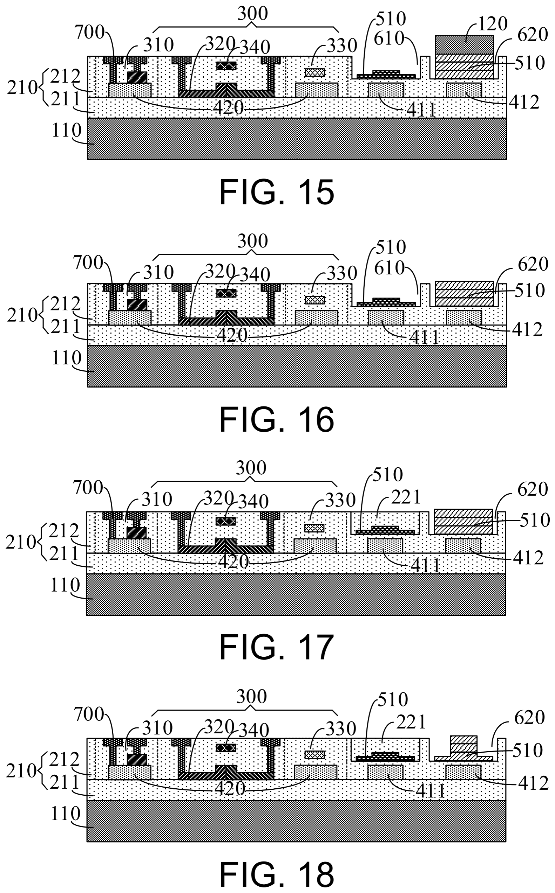

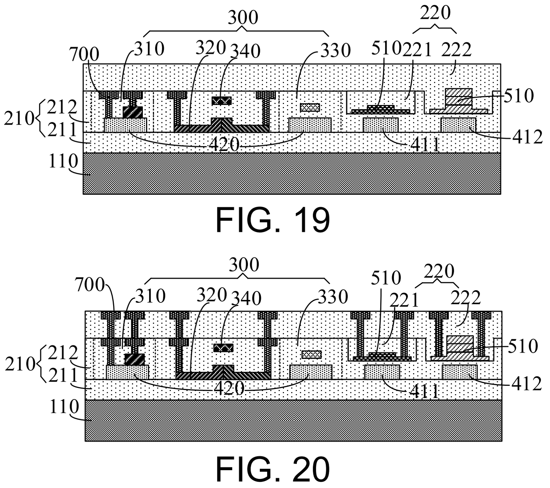

In an embodiment, please refer to FIG. 10 to FIG. 20, the first waveguide 410 includes a first sub-waveguide 411 and a second sub-waveguide 412. The semi-finished chip includes a first semi-finished chip and a second semi-finished chip. The first semi-finished chip is optically coupled to and connected with the first sub-waveguide 411, and the second semi-finished chip is optically coupled to and connected with the second sub-waveguide 412.

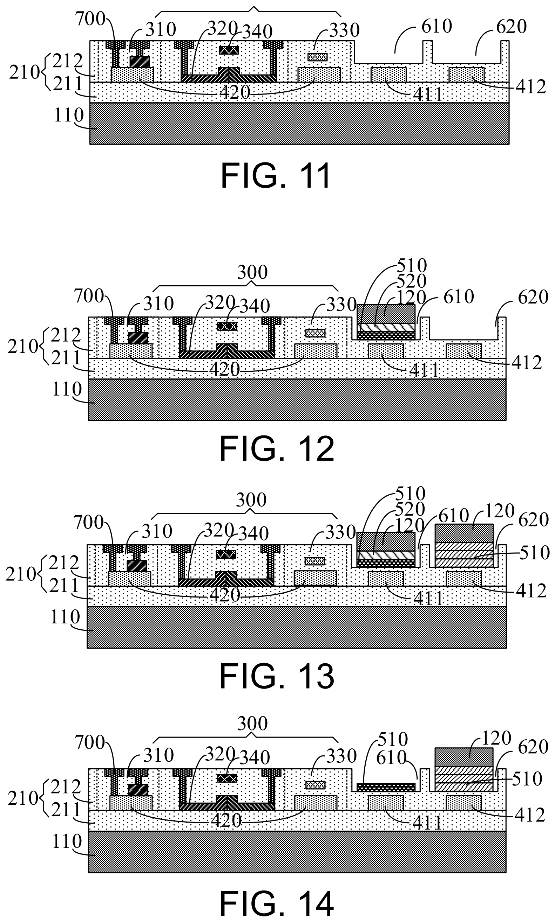

As an example, the first semi-finished chip may be a thin-film lithium niobate chip, and the second semi-finished chip may be a laser chip. Under the circumstances, please refer to FIG. 11, the recess 600 includes a first recess 610 and a second recess 620. Please refer to FIG. 12, the thin-film lithium niobate chip may be bonded in the first recess 610 through the thin-film lithium niobate layer. Please refer to FIG. 13, the laser chip may be bonded in the second recess 620 through the Group III-V semiconductor material thin-film layer. The thin-film lithium niobate chip is optically coupled to and connected with the first sub-waveguide 411, and the laser chip is optically coupled to and connected with the second sub-waveguide 412. The thin-film lithium niobate chip and the laser chip are optically connected together through the first sub-waveguide 411 and the second sub-waveguide 412.

The second recess 620 may be formed in the isolation dielectric layer 210 along with the first recess 610. Of course, the second recess 620 may also be formed after completing the bonding of the thin-film lithium niobate chip, and the formation time of the second recess 620 is not limited here.

Please refer to FIG. 12 and FIG. 13, the thin-film lithium niobate chip may be bonded into the first recess 610, and then the laser chip may be bonded into the second recess 620. Then, the substrate of the thin-film lithium niobate chip is removed, and the first recess 610 is filled in sequence. Thereafter, the substrate of the laser chip is removed.

Alternatively, the laser chip may be bonded into the second recess 620 after bonding the thin-film lithium niobate chip in the first recess 610.

Then, the removal of the substrate of the laser chip may be performed while removing the substrate of the thin-film lithium niobate chip.

Conventional silicon photonic chips offer advantages of high integration and low cost, while the germanium-silicon high-speed detectors on silicon photonic chips exhibit a good performance. However, conventional silicon photonic chips also have disadvantages such as the inability to emit light and limited modulator bandwidth. A single thin-film lithium niobate modulator boasts high bandwidth and low loss but is unable to integrate other detectors nor emit light. A single laser, while capable of emitting light, suffers from poor integration and high cost. In this embodiment, the first semi-finished chip and the second semi-finished chip are simultaneously bonded within the photonic chip. The first semi-finished chip may subsequently form a lithium niobate modulator, and the second semi-finished chip may subsequently form a laser. The laser emits light, which is received and output by the lithium niobate modulator. Additionally, the photonic chip also incorporates the first semiconductor optical device 300, which may serve as a receiving end of the photonic chip to receive light from the lithium niobate modulator as well as external light. Through this hybrid integration approach, a complete silicon photonic chip is formed, leveraging the complementary advantages of various structures and the silicon photonic chip to achieve the optoelectronic transmission and reception functions of the silicon photonic chip.

In an embodiment, the first semiconductor optical device 300 includes a waveguide layer 420, and the first waveguide 410 and the waveguide layer 420 of the first semiconductor optical device 300 are located at the same layer.

As an example, the waveguide layer 420 of the first semiconductor optical device 300 may be formed together with the first waveguide 410, that is, both are formed in one process flow. For example, a waveguide material layer may be formed on the first dielectric layer 211 first, and then the waveguide material layer may be etched to form the waveguide layer 420 and the first waveguide 410.

In this example, the waveguide layer 420 and the first waveguide 410 are formed in one process flow, which saves process steps and improves process efficiency.

It should be understood that, although the steps in the flowchart of FIG. 1 are depicted sequentially as indicated by the arrows, these steps are not necessarily executed in the order dictated by the arrows. Unless explicitly stated otherwise in this document, there is no strict sequence required for the execution of these steps, and they may be performed in a different order. Furthermore, at least a portion of the steps in FIG. 1 may include multiple steps or stages, which are not necessarily completed at the same time but may be executed at different times. The order of execution of these steps or stages is also not necessarily sequential, and they may be performed alternately or in rotation with at least a part of other steps or stages within other steps.

In an embodiment, please refer to FIG. 2, an optical chip structure is provided, including the base, the second semiconductor optical device, and the electrode structure 700.

The base includes the first substrate 110, the isolation dielectric layer 210 located on the first substrate 110, the first semiconductor optical device 300, and the first waveguide 410.

As an example, the isolation dielectric layer 210 includes the first dielectric layer 211 and the second dielectric layer 212. The first dielectric layer 211 is located on the first substrate 110. The second dielectric layer 212 is located on the first substrate 110. The first semiconductor optical device 300 and the first waveguide 410 are located within the second dielectric layer 212.

The second semiconductor optical device is bonded to the isolation dielectric layer 210 on the first waveguide 410, and is optically coupled to and connected with the first waveguide 410, and the first waveguide 410 is at least partially located between the second semiconductor optical device and the first substrate 110.

The first semiconductor optical device 300 and the second semiconductor optical device are optically connected through the first waveguide 410.

As an example, the first semiconductor optical device 300 may be a detector, the second semiconductor optical device may be a lithium niobate modulator, and the first semiconductor optical device 300 and the second semiconductor optical device may be optically connected to each other through the first waveguide 410.

As an example, the isolation dielectric layer 210 includes the first dielectric layer 211 and the second dielectric layer 212, and the second semiconductor optical device is bonded within the second dielectric layer 212.

The length of the first waveguide 410 may be greater than a width of the second optical device.

The electrode structure 700 is connected to the first semiconductor optical device 300 and the second semiconductor optical device, respectively.

In this embodiment, the second semiconductor optical device and the first semiconductor optical device 300 are integrated together in the optical chip. The first semiconductor optical device 300 serves as a receiving end of the entire optical chip, the second semiconductor optical device serves as a transmitting end of the entire optical chip, and both the transmitting end and the receiving end are integrated in a single optical chip, which may well implement the optical transceiver function and meet the requirements of next-generation optical transceiver modules.

In an embodiment, there is the isolation dielectric layer 210 with the preset thickness between the first waveguide 410 and the second semiconductor optical device. The second semiconductor optical device may not contact the first waveguide 410, and the isolation dielectric layer 210 with the preset thickness is retained between them. For example, the preset thickness may be 80nm.

In an embodiment, the optical chip structure further includes the protective dielectric layer 220. The protective dielectric layer 220 covers the second semiconductor optical device.

In an embodiment, the first waveguide 410 includes the first sub-waveguide 411 and the second sub-waveguide 412. The second semiconductor optical device includes the first semiconductor sub-device and the second semiconductor sub-device. The first semiconductor sub-device is optically coupled to and connected with the first sub-waveguide 411, and the second semiconductor sub-device is optically coupled to and connected with the second sub-waveguide 412.

As an example, the first semiconductor sub-device may be a lithium niobate modulator, the second semiconductor sub-device may be a laser, the lithium niobate modulator is optically coupled to and connected with the first sub-waveguide 411, and the laser is optically coupled to and connected with the second sub-waveguide 412. Moreover, the lithium niobate modulator and the laser are optically connected to each other through the first sub-waveguide 411 and the second sub-waveguide 412.

In the entire optical chip, the first semiconductor sub-device may be a lithium niobate modulator, the second semiconductor sub-device may be a laser, and the first semiconductor optical device 300 may be a silicon germanium high-speed modulator. The laser emits optical signals, the lithium niobate modulator receives the optical signals emitted by the laser, processes outputs the optical signals, and the silicon germanium high-speed modulator receives optical signals from the lithium niobate modulator and optical signals from outside the optical chip.

In the description of this specification, descriptions referring to terms such as "some embodiments", "other embodiments", "ideal embodiments", and the like mean that specific features, structures, materials or features described in combination with the embodiment or example are included in at least one embodiment or example of the present disclosure. In this specification, the schematic descriptions of the above terms do not necessarily refer to the same embodiment or example.

The technical features of the above-described embodiments may be combined freely. To make the description concise, not all possible combinations of the technical features of the above embodiments have been described. However, as long as there is no contradiction in the combination of these technical features, they should all be considered within the scope recited in this specification.

The above-described embodiments only express several implementation modes of the present disclosure, and their descriptions are relatively specific and detailed, but this should not be understood as limitations on the scope of the patent application. It should be pointed out that for those of ordinary skill in the art, several modifications and improvements may be made without departing from the concept of the present disclosure, and these all belong to the scope to be protected by the present disclosure. Therefore, the scope to be protected by this patent application should be subject to the appended claims.

## Claims

1. A method for manufacturing an optical chip structure, **characterized in** comprising:
providing a base and a semi-finished chip, wherein the base comprises a first substrate, an isolation dielectric layer formed on the first substrate, a first semiconductor optical device, and a first waveguide, the semi-finished chip comprises a second substrate and a semi-finished thin-film layer located on one side of the second substrate, the semi-finished thin-film layer and the first waveguide are made of materials of different material systems, and the first substrate comprises a silicon substrate;
forming a recess in the isolation dielectric layer, wherein the first waveguide is at least partially located between the recess and the first substrate;
bonding the semi-finished chip in the recess through the semi-finished thin-film layer, so that the semi-finished thin-film layer is optically coupled to the first waveguide;
removing the second substrate of the semi-finished chip to form a second semiconductor optical device;
carrying out metallization to form electrode structures separately connected to the first semiconductor optical device and the second semiconductor optical device.

2. The method for manufacturing the optical chip structure according to claim 1, **characterized in that** the isolation dielectric layer with a preset thickness is provided between a bottom of the recess and the first waveguide;
the operation of bonding the semi-finished chip in the recess through the semi-finished thin-film layer so that the semi-finished thin-film layer is optically coupled to the first waveguide comprises:
bonding the semi-finished thin-film layer with the isolation dielectric layer.

3. The method for manufacturing the optical chip structure according to claim 1, **characterized in that** the semi-finished chip comprises a thin-film lithium niobate chip, the semi-finished thin-film layer comprises a thin-film lithium niobate layer, and the formed second semiconductor optical device comprises a lithium niobate modulator.

4. The method for manufacturing the optical chip structure according to claim 1, **characterized in that** the semi-finished chip comprises a laser chip, the semi-finished thin-film layer comprises a Group III-V semiconductor material thin-film layer, and the formed second semiconductor optical device comprises a laser.

5. The method for manufacturing the optical chip structure according to claim 1, **characterized in that** the operation of removing the second substrate of the semi-finished chip to form the second semiconductor optical device comprises:
removing the second substrate of the semi-finished chip;
etching the semi-finished thin-film layer to form an electrode contact region and an optical processing region;
filling a protective dielectric layer in the recess, and the protective dielectric layer covers the second semiconductor optical device.

6. The method for manufacturing the optical chip structure according to claim 1, **characterized in that** the first waveguide comprises a first sub-waveguide and a second sub-waveguide, the semi-finished chip comprises a first semi-finished chip and a second semi-finished chip, the first semi-finished chip is optically coupled to and connected with the first sub-waveguide, and the second semi-finished chip is optically coupled to and connected with the second sub-waveguide.

7. The method for manufacturing the optical chip structure according to claim 6, **characterized in that** the first semi-finished chip is a thin-film lithium niobate chip, the second semi-finished chip is a laser chip, and the first semi-finished chip and the second semi-finished chip are optically connected to each other through the first sub-waveguide and the second sub-waveguide.

8. The method for manufacturing the optical chip structure according to claim 1, **characterized in that** the first semiconductor optical device comprises a waveguide layer, and the first waveguide and the waveguide layer of the first semiconductor optical device are located at a same layer.

9. The method for manufacturing the optical chip structure according to claim 8, **characterized in that** the first waveguide and the waveguide layer of the first semiconductor optical device are formed in one process flow.

10. An optical chip structure, **characterized in** comprising:
a base, comprising a first substrate, an isolation dielectric layer located on the first substrate, a first semiconductor optical device, and a first waveguide;
a second semiconductor optical device, bonded to the isolation dielectric layer on the first waveguide, and optically coupled to and connected with the first waveguide, wherein the first waveguide is at least partially located between the second semiconductor optical device and the first substrate;
electrode structures, connected to the first semiconductor optical device and the second semiconductor optical device, respectively;
the first semiconductor optical device and the second semiconductor optical device are optically connected to each other through the first waveguide.

11. The optical chip structure according to claim 10, **characterized in that** the isolation dielectric layer with a preset thickness is provided between the first waveguide and the second semiconductor optical device.

12. The optical chip structure according to claim 10, **characterized in** further comprising:
a protective dielectric layer, covering the second semiconductor optical device.

13. The optical chip structure according to claim 10, **characterized in that** the first waveguide comprises a first sub-waveguide and a second sub-waveguide, the second semiconductor optical device comprises a first semiconductor sub-device and a second semiconductor sub-device, the first semiconductor sub-device is optically coupled to and connected with the first sub-waveguide, and the second semiconductor sub-device is optically coupled to and connected with the second sub-waveguide.

14. The optical chip structure according to claim 13, **characterized in that** the first semiconductor sub-device is a lithium niobate modulator, the second semiconductor sub-device is a laser, and the first semiconductor sub-device and the second semiconductor sub-device are optically connected to each other through the first sub-waveguide and the second sub-waveguide.

15. The optical chip structure according to claim 10, **characterized in that** the first semiconductor optical device is a detector, the second semiconductor optical device is a lithium niobate modulator, and the first semiconductor optical device and the second semiconductor optical device are optically connected to each other through the first waveguide.
